# EUROPÄISCHE PATENTSCHRIFT

(11) **EP 3 192 155 B1**
(45) Veröffentlichungstag und Bekanntmachung des Hinweises auf die Patenterteilung: **23.08.2023**
(21) Anmeldenummer: 15759443.3
(22) Anmeldetag: 03.09.2015
(51) Int. Cl.: H02K 11/40, H05K 1/02, H05K 1/18

(54) **ELEKTROMOTOR MIT SMD-BAUTEILEN UND ZUGEHÖRIGES VERBINDUNGSTEIL**
ELECTRIC MOTOR HAVING SMD COMPONENTS AND ASSOCIATED CONNECTION COMPONENT
MOTEUR ÉLECTRIQUE POURVU DE COMPOSANTS CMS ET ÉLÉMENT DE LIAISON ASSOCIÉ

(30) Priorität: 08.09.2014 DE 102014217933
(43) Veröffentlichungstag der Anmeldung: 19.07.2017
(73) Patentinhaber: Vitesco Technologies GmbH, 93055 Regensburg (DE)
(72) Erfinder: WALLRAFEN, Werner, 65795 Hattersheim (DE); MURESAN, Daniel, R-307220 Giroc (RO)
(74) Vertreter: Vitesco Technologies
(86) Internationale Anmeldenummer: PCT/EP2015/070188
(87) Internationale Veröffentlichungsnummer: WO 2016/037927

(56) Entgegenhaltungen:
- DE-A1-102005 007 611
- DE-A1-102012 006 499
- US-B1- 6 768 243

## Beschreibung

Die vorliegende Erfindung betrifft einen Elektromotor mit einer Vielzahl von in Vertiefungen oder Kammern eines Trägers des Elektromotors angeordneten SMD-Bauteilen und einem Verbindungsteil für die SMD-Bauteile.

SMD-Bauteile (SMD: Surface Mounted Device) zeichnen sich gegenüber bedrahteten elektronischen Bauteilen durch ihre kompakte Bauform und einfache Bestückung aus. Standardmäßig werden sie auf Leiterplatten oder Keramiksubstraten aufgebracht und mit Leiterbahnen der Leiterplatten verlötet. Die Leiterbahnen müssen dann ihrerseits mit weiteren elektrischen Anschlüssen verbunden werden, insbesondere über Anschlusskabel oder Drähte. Die vorliegende Erfindung bezieht sich auf die Anbringung von derartigen SMD-Bauteilen an einem Träger eines Elektromotors.

Aus der DE 10 2012 006 499 A1 ist ein Elektromotor mit einem elektrisch leitfähigen Motorgehäuse und mit einem Bürstenträger, der eine Aufnahmetasche für eine bestückte Leiterplatte aufweist, bekannt. Die Leiterplatte ist mittels an Kontaktstellen federnd anliegender Kontaktzungen klemmfixiert. Ein U-förmiger Massefederkontakt ist als Stanz-Biegeteil ausgebildet und hat einen vergleichsweise kurzen Klemmschenkel sowie einen vergleichsweise langen Klemmschenkel. Die beiden Klemmschenkel sind über einen Federschenkel verbunden.

Die DE 10 2005 007 611 A1 beschreibt einen Elektromotor mit Entstörvorrichtung, bei dem mehrere Kondensatoren parallel auf ein Paar von gleichen benachbarten Segmenten gelötet sind. Dadurch kann die Entladungskapazität zwischen Kommutatorsegmenten erhöht werden.

Aus der US 6 768 243 B1 ist ein Elektromotor bekannt, der ein Verbindungsteil aufweist, das einen Kondensator mit der Gehäusewand des Elektromotors verbindet. Das Verbindungsteil weist hierbei zwei Klemmschenkel auf, die allein aus symmetrischen Gründen zur Erleichterung der Montage vorgesehen sind, da hiermit lediglich ein einziger Kondensator an Masse angeschlossen werden soll.

Weitere Verbindungsteile dieser Art, die entweder zur Verbindung von Leiterplatten oder zur Verbindung von einzelnen Bauteilen dienen, sind in der DE 10 2004 037 912 A1, der DE 198 58 627 A1 und der DE 10 2006 026 477 A1 beschrieben.

Der Erfindung liegt die Aufgabe zugrunde, einen Elektromotor der eingangs beschriebenen Art zur Verfügung zu stellen, bei dem die Verbindung der SMD-Bauteile mit einem Gehäuseteil des Elektromotors besonders einfach ausgebildet ist.

Diese Aufgabe wird erfindungsgemäß durch einen Elektromotor gemäß Patentanspruch 1 gelöst.

Erfindungsgemäß wird eine einfache und praktische Lösung zur Verfügung gestellt, um eine entsprechende Vielzahl von SMD-Bauteilen mit einem Gehäuseteil des Elektromotors elektrisch zu verbinden. Hierfür findet eine Kontaktfeder Verwendung, die eine entsprechende Vielzahl von Kontaktfingern besitzt, die jeweils mit einer SMD-Vorrichtung in Kontakt stehen. Diese Kontaktfinger gehen von einem Hauptabschnitt der Kontaktfeder aus, von dessen anderer Seite aus sich mindestens ein Kontaktabschnitt erstreckt, der für die elektrische Verbindung der Kontaktfeder mit dem elektrisch leitfähigen Gehäuseteil dient. Die Kontaktfeder besteht aus federndem Material, wie Stahl, wodurch Leadframe-Material, das am Ende verdünnt ist, vermieden wird. Die Kontaktfeder kann mit Zinn, Nickel, Silber oder anderen Materialien plattiert sein, um einen Korrosionsschutz vorzusehen.

Erfindungsgemäß wird somit ein einziges leicht herzustellendes Bauteil dazu eingesetzt, um eine Vielzahl von SMD-Bauteilen mit dem Gehäuseteil elektrisch zu verbinden.

Bei dem Gehäuseteil kann es sich beispielsweise um die Gehäuseaußenwand des Elektromotors handeln. Der Träger kann ein Bürstenhalter des Elektromotors sein.

Die erfindungsgemäß vorgesehene einzige Kontaktfeder steht über die Kontaktfinger mit einer Seite der SMD-Bauteile in Verbindung. Hierbei sind die SMD-Bauteile an den Kontaktfingern elektrisch leitend fixiert, insbesondere durch Klemmen und/oder Löten bzw. Leitkleben.

Die SMD-Bauteile können in ein Isolationsmaterial eingebettet oder hiermit beschichtet sein, um einen entsprechenden Feuchtigkeitsschutz vorzusehen.

Es versteht sich, dass die Kontaktfeder aus elektrisch leitendem Material besteht und die SMD-Bauteile durch Verbindung mit dem elektrisch leitenden Gehäuseteil erdet. Dieses Gehäuseteil ist beispielsweise Teil eines metallischen Motorgehäuses.

Wie vorstehend erwähnt, wird die Kontaktfeder auf den Träger des Elektromotors aufgeklemmt. Zusätzlich dazu weist der Mittelabschnitt der Kontaktfeder auf der Seite der Kontaktfinger für die SMD-Bauteile und/oder auf der Seite des mindestens einen Kontaktabschnitts für das Gehäuseteil mindestens eine Fixierungsklemme auf. Hierdurch erfolgt eine zusätzliche Fixierung der Kontaktfeder am Träger. Bei diesen Fixierungsklemmen handelt es sich um einwärts vorstehende Abschnitte, beispielsweise des Hauptabschnitts der Kontaktfeder, , die beim Aufsetzen der Kontaktfeder auf den Träger sich in den Träger eingraben und auf diese Weise für eine zusätzliche Fixierung sorgen.

Bei einer weiteren bevorzugten Ausführungsform ist zwischen benachbarten SMD-Bauteilen eine isolierende Schutzwand zur Vermeidung von Kurzschlüssen angeordnet.

Die SMD-Bauteile sind in Vertiefungen oder Kammern des Trägers eingelassen. Die Kontaktfinger der Kontaktfeder greifen dabei in die einzelnen Kammern ein und treten dort mit den in den Kammern angeordneten SMD-Bauteilen in Kontakt.

Erfindungsgemäß kommt somit eine vorzugsweise aus Stahl bestehende Kontaktfeder zum Einsatz, die eine Vielzahl von SMD-Bauteilen oder sämtliche SMD-Bauteile des Elektromotors mit einem Gehäuseteil des Motors verbindet. Hierzu besitzt die Kontaktfeder eine Vielzahl von Kontaktfingern für eine Vielzahl von SMD-Bauteilen oder für sämtliche SMD-Bauteile. Auf der gegenüberliegenden Seite der Feder ist mindestens ein Kontaktabschnitt zur Herstellung eines elektrischen Kontaktes mit einem elektrisch leitfähigen Gehäuseteil, vorzugsweise der metallischen Gehäuseaußenwand des Motors, vorgesehen.

Die vorliegende Erfindung betrifft ferner ein Verbindungsteil mit den Merkmalen von Patentanspruch 11.

Die Kontaktfeder besitzt einen U-förmigen Hauptabschnitt, von dessen einem Schenkel die Kontaktfinger und von dessen anderem Schenkel der mindestens eine Kontaktabschnitt ausgehen.

Mit dem U-förmigen Hauptabschnitt wird die Kontaktfeder beispielsweise auf einen Träger eines Elektromotors aufgeklemmt. Die Vielzahl der Kontaktfinger kann dann mit einer Vielzahl von SMD-Bauteilen in Kontakt treten, die am Träger des Motors angeordnet sind. Der von der anderen Seite des Hauptabschnitts ausgehende federnde Kontaktabschnitt dient zur Herstellung einer elektrischen Verbindung mit dem Gehäuseteil.

Der Mittelabschnitt der Kontaktfeder weist auf seinen beiden Schenkeln mindestens eine Fixierungsklemme auf, bei der es sich um einen nach innen abgebogenen Abschnitt der Feder handelt, der sich beispielsweise beim Aufsetzen der Kontaktfeder auf den Träger in diesen eingräbt und somit für eine zusätzliche Fixierung der Feder sorgt.

Die Erfindung wird nachfolgend anhand von Ausführungsbeispielen in Verbindung mit der Zeichnung im Einzelnen erläutert. Es zeigen:
- Figur 1: eine räumliche Ansicht einer ersten Ausführungsform einer Kontaktfeder;
- Figur 2: eine räumliche Ansicht der Kontaktfeder der Figur 1 von der gegenüberliegenden Seite aus gesehen;
- Figur 3: eine räumliche Ansicht einer anderen Ausführungsform einer Kontaktfeder; und
- Figur 4: eine schematische Schnittansicht eines eingebauten SMD-Bauteils mit Kontaktfeder.

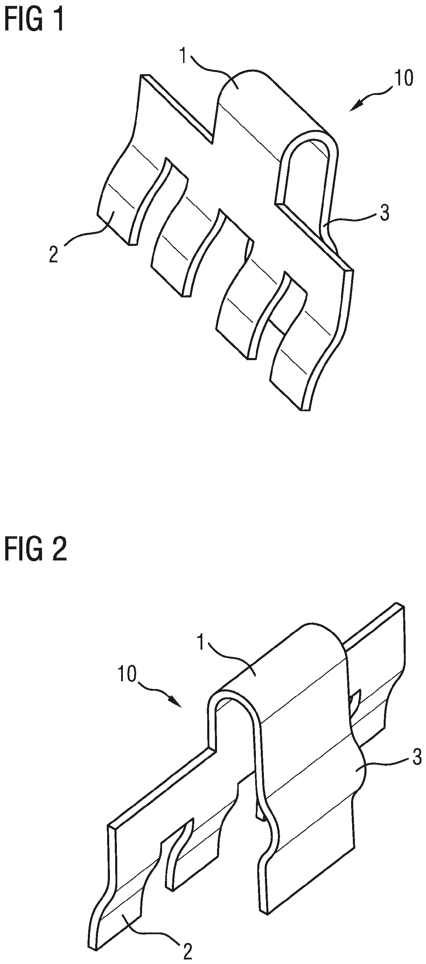

Die in den Figuren 1 und 2 gezeigte Kontaktfeder 10 dient zum Verbinden von vier SMD-Bauteilen mit einem elektrisch leitfähigen Gehäuseteil eines Elektromotors. Die Kontaktfeder besteht aus federndem Material, hier dünnem Stahlblech, und besitzt einen U-förmigen Hauptabschnitt 1, der die Form eines umgedrehten U hat. Von einem Schenkel des U-förmigen Hauptabschnitts 1, nämlich dem vorderen Schenkel in Figur 1, gehen vier Kontaktfinger 2 aus, die vom Hauptabschnitt aus nach vorne gekrümmt sind und nach dem Einbau der Kontaktfeder mit je einem SMD-Bauteil in Kontakt treten. Vom rückseitigen Schenkel in Figur 1 geht ein federnder Kontaktabschnitt 3 aus. Der U-förmige Hauptabschnitt 1 wird auf einen Träger 6 des Elektromotors gesetzt und auf diesen aufgeklemmt, wobei der rückwärtige federnde Kontaktabschnitt 3 den Kontakt mit der elektrisch leitfähigen Gehäusewand 8 (Gehäuseteil) sichert und die vorderen gekrümmten federnden Kontaktfinger 2 den Kontakt mit den SMD-Bauteilen herstellen.

Bei der dargestellten Ausführungsform erweitert sich der vordere Schenkel des U-förmigen Hauptabschnittes beidseitig, um in die vier Kontaktfinger 2 überzugehen.

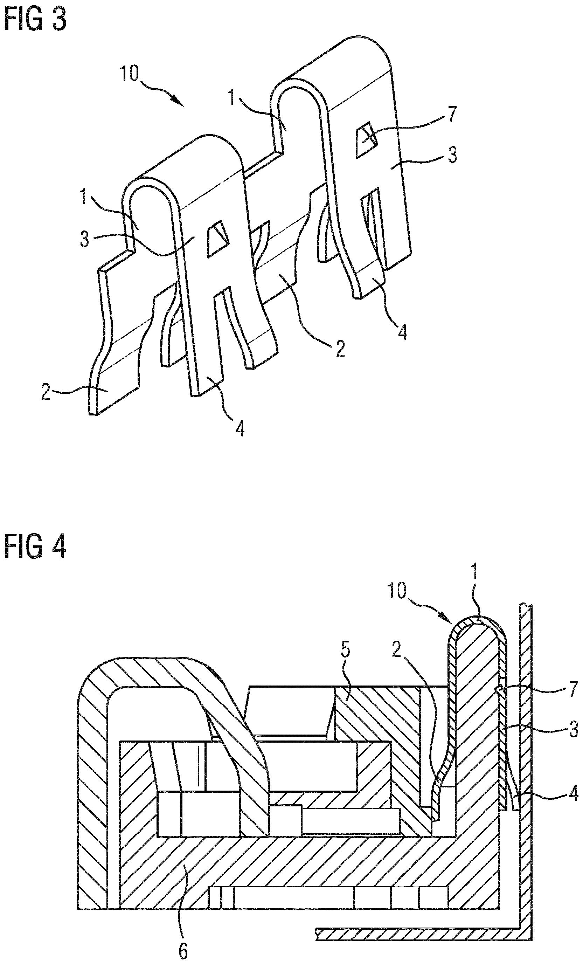

Figur 3 zeigt eine andere Ausführungsform einer Kontaktfeder 10. Bei dieser Ausführungsform ist der Hauptabschnitt 1 in zwei U-förmige Unterabschnitte unterteilt, die ebenfalls die Form eines umgedrehten U besitzen. Die beiden rückwärtigen Schenkel des U-förmigen Hauptabschnitts 1 gehen ebenfalls jeweils in einen sich nach unten erstreckenden, federnden Kontaktabschnitt 3 über, der bei dieser Ausführungsform zwei geteilte fingerförmige Abschnitte 4 besitzt. Die beiden vorderen Schenkel des U-förmigen Hauptabschnitts 1 erweitern sich und gehen in vier nach vorne gekrümmte Kontaktfinger 2 über, die den Kontakt mit vier SMD-Bauteilen 5 herstellen. Auch hier wird der Hauptabschnitt 1 mit seinen beiden Unterabschnitten auf einen Träger 6 eines Elektromotors gesetzt und dort festgeklemmt.

Die beiden rückwärtigen Schenkel des U-förmigen Hauptabschnitts 1 sind mit je einer Fixierungsklemme 7 versehen, bei der es sich um einen nach innen vorstehenden Abschnitt handelt, der sich beim Aufsetzen der Kontaktfeder auf den Träger 6 in diesen eingräbt und die Feder fixiert.

Figur 4 zeigt in schematischer Schnittansicht eine montierte Kontaktfeder 10. Ein SMD-Bauteil 5 (nur schematisch dargestellt) ist in einer Ausnehmung eines Trägers 6 eines Elektromotors angeordnet. Die Kontaktfeder 10 mit beispielsweise der in Figur 3 dargestellten Ausführungsform umgreift mit ihrem U-förmigen Hauptabschnitt 1 einen Teil des Trägers 6 und ist auf diesen aufgeklemmt, wobei sich die Fixierungsklemme 7 in die entsprechende Wand hinein erstreckt. Die Kontaktfinger 2 der Kontaktfeder 10 kontaktieren im eingebauten Zustand die entsprechenden SMD-Bauteile 5, während sich der gegenüberliegende federnde Kontaktabschnitt 3 an der gegenüberliegenden Seite des Trägers 6 nach unten erstreckt und mit einem Abschnitt 4 die metallische Gehäusewand 8 des Elektromotors elektrisch kontaktiert.

## Patentansprüche

1. Elektromotor mit einer Vielzahl von in Vertiefungen oder Kammern eines Trägers (6) des Elektromotors angeordneten SMD-Bauteilen (5) und einem Verbindungsteil für die SMD-Bauteile (5) mit einem elektrisch leitfähigen Gehäuseteil des Elektromotors, wobei das Verbindungsteil als auf den Träger (6) aufgeklemmte Kontaktfeder (10) ausgebildet ist, **dadurch gekennzeichnet, dass** das Verbindungsteil eine Vielzahl von SMD-Bauteilen (5) mit dem Gehäuseteil elektrisch verbindet und hierzu einen Hauptabschnitt (1), eine sich von einer Seite desselben aus erstreckende Vielzahl von federnden Kontaktfingern (2) für die SMD-Bauteile (5), die in die einzelnen Vertiefungen oder Kammern eingreifen und dort mit den in den Vertiefungen oder Kammern angeordneten SMD-Bauteilen (5) in Kontakt treten, und mindestens einen sich von der anderen Seite des Hauptabschnitts (1) aus erstreckenden federnden Kontaktabschnitt (3) zur elektrischen Verbindung mit dem Gehäuseteil aufweist, und wobei der Hauptabschnitt (1) der Kontaktfeder (10) auf der Seite der Kontaktfinger (2) für die SMD-Bauteile (5) und/oder auf der Seite des mindestens einen Kontaktabschnitts (3) für das Gehäuseteil mindestens eine Fixierungsklemme (7) aufweist, die als einwärts vorstehender Abschnitt ausgebildet ist.

2. Elektromotor nach Anspruch 1, **dadurch gekennzeichnet, dass** das Gehäuseteil eine Gehäuseaußenwand (8) des Elektromotors ist.

3. Elektromotor nach Anspruch 1 oder 2, **dadurch gekennzeichnet, dass** der Träger (6) ein Bürstenhalter des Elektromotors ist.

4. Elektromotor nach einem der Ansprüche 2 oder 3, **dadurch gekennzeichnet, dass** die Kontaktfeder (10) auf den Träger (6) des Elektromotors aufgeklemmt ist.

5. Elektromotor nach einem der vorangehenden Ansprüche, **dadurch gekennzeichnet, dass** der Träger (6) aus einem isolierenden Kunststoff besteht.

6. Elektromotor nach einem der vorangehenden Ansprüche, **dadurch gekennzeichnet, dass** die SMD-Bauteile (5) an den Kontaktfingern (2) elektrisch leitfähig fixiert sind, insbesondere durch Klemmen und/oder Löten bzw. Leitkleben.

7. Elektromotor nach einem der vorangehenden Ansprüche, **dadurch gekennzeichnet, dass** die SMD-Bauteile (5) in ein Isoliermaterial eingebettet oder hiermit beschichtet sind.

8. Elektromotor nach Anspruch 7, **dadurch gekennzeichnet, dass** das Isoliermaterial flexibel und nachgiebig ist.

9. Elektromotor nach einem der vorangehenden Ansprüche, **dadurch gekennzeichnet, dass** zwischen benachbarten SMD-Bauteilen (5) eine isolierende Schutzwand zur Vermeidung von Kurzschlüssen angeordnet ist.

10. Verbindungsteil für einen Elektromotor nach einem der vorangehenden Ansprüche zum Verbinden einer Vielzahl von in Vertiefungen oder Kammern eines Trägers des Elektromotors angeordneten SMD-Bauteilen mit einem elektrisch leitfähigen Gehäuseteil des Elektromotors, das als Kontaktfeder (10) ausgebildet ist, **dadurch gekennzeichnet, dass** das Verbindungsteil einen Hauptabschnitt (1), eine sich von einer Seite desselben aus erstreckende Vielzahl von federnden Kontaktfingern (2) für die SMD-Bauteile (5) und mindestens einen sich von der anderen Seite des Hauptabschnitts (1) aus erstreckenden, federnden Kontaktabschnitt (3) für das elektrisch leitfähige Gehäuseteil aufweist, wobei die Kontaktfeder (10) einen U-förmigen Hauptabschnitt (1) aufweist, von dessen einem Schenkel die Kontaktfinger (2) und von dessen anderem Schenkel mindestens ein Kontaktabschnitt (3) ausgehen, und wobei der Hauptabschnitt (1) der Kontaktfeder (10) auf der Seite der Kontaktfinger (2) für die SMD-Bauteile (5) und/oder auf der Seite des mindestens einen Kontaktabschnitts (3) für das Gehäuseteil mindestens eine Fixierungsklemme (7) aufweist, die als einwärts vorstehender Abschnitt ausgebildet ist.

## Claims

1. Electric motor with a multiplicity of SMD components (5) which are arranged in depressions or chambers of a carrier (6) of the electric motor, and with a connecting part for the SMD components (5) with an electrically conductive housing part of the electric motor, the connecting part being configured as a contact spring (10) which is clipped onto the carrier (6), **characterized in that** the connecting part electrically connects a multiplicity of SMD components (5) to the housing part and, to this end, comprises a main portion (1), a multiplicity of resilient contact fingers (2) for the SMD components (5) which extend from one side of the said main portion (1), engage into the individual depressions or chambers, and come into contact there with the SMD components (5) which are arranged in the depressions or chambers, and at least one resilient contact portion (3) which extends from the other side of the main portion (1) for electric connection to the housing part, and
the main portion (1) of the contact spring (10) comprising, on the side of the contact fingers (2) for the SMD components (5) and/or on the side of the at least one contact portion (3) for the housing part, at least one fixing terminal (7) which is configured as an inwardly projecting portion.

2. Electric motor according to Claim 1, **characterized in that** the housing part is a housing outer wall (8) of the electric motor.

3. Electric motor according to Claim 1 or 2, **characterized in that** the carrier (6) is a brush holder of the electric motor.

4. Electric motor according to either of Claims 2 or 3, **characterized in that** the contact spring (10) is clipped onto the carrier (6) of the electric motor.

5. Electric motor according to one of the preceding claims, **characterized in that** the carrier (6) consists of an insulating plastic.

6. Electric motor according to one of the preceding claims, **characterized in that** the SMD components (5) are fixed on the contact fingers (2) in an electrically conductive manner, in particular by way of clipping and/or soldering or conductive gluing.

7. Electric motor according to one of the preceding claims, **characterized in that** the SMD components (5) are embedded into an insulating material or are coated with the latter.

8. Electric motor according to Claim 7, **characterized in that** the insulating material is flexible and compliant.

9. Electric motor according to one of the preceding claims, **characterized in that** an insulating protective wall for avoiding short circuits is arranged between adjacent SMD components (5).

10. Connecting part for an electric motor according to one of the preceding claims for connecting a multiplicity of SMD components, arranged in depressions or chambers of a carrier of the electric motor, to an electrically conductive housing part of the electric motor, which housing part is configured as a contact spring (10), **characterized in that** the connecting part comprises a main portion (1), a multiplicity of resilient contact fingers (2) for the SMD components (5) which extend from one side of the said main portion (1), and at least one resilient contact portion (3), extending from the other side of the main portion (1), for the electrically conductive housing part, the contact spring (10) comprising a U-shaped main portion (1), from the one limb of which the contact fingers (2) emanate and from the other limb of which at least one contact portion (3) emanates,
and the main portion (1) of the contact spring (10) comprising a fixing terminal (7), which is configured as an inwardly projecting portion, on the side of the contact fingers (2) for the SMD components (5) and/or on the side of the at least one contact portion (3) for the housing part.

## Revendications

1. Moteur électrique comprenant une pluralité de composants CMS (5) disposés dans des cavités ou des chambres d'un élément porteur (6) du moteur électrique et une pièce de liaison pour les composants CMS (5) avec une partie de carter électriquement conductrice du moteur électrique, la pièce de liaison étant réalisée sous la forme d'un ressort de contact (10) collé sur l'élément porteur (6), **caractérisé en ce que** la pièce de liaison relie électriquement une pluralité de composants CMS (5) à la partie de carter et possède à cet effet une portion principale (1), une pluralité de languettes de contact flexibles (2) pour les composants CMS (5), qui s'étendent depuis un côté de celle-ci, pénètrent dans les cavités ou les chambres individuelles et y entrent en contact avec les composants CMS (5) qui sont disposés dans les cavités ou les chambres, et au moins une portion de contact flexible (3), qui s'étend depuis l'autre côté de la portion principale (1), destinée à la liaison électrique avec la partie de carter, et la portion principale (1) possédant le ressort de contact (10) sur le côté des languettes de contact (2) pour les composants CMS (5) et/ou, sur le côté de l'au moins une portion de contact flexible (3) pour la partie de carter, au moins une pince de blocage (7) qui est réalisée sous la forme d'une portion faisant saillie vers l'intérieur.

2. Moteur électrique selon la revendication 1, **caractérisé en ce que** la partie de carter est une paroi extérieure de carter (8) du moteur électrique.

3. Moteur électrique selon la revendication 1 ou 2, **caractérisé en ce que** l'élément porteur (6) est un porte-balais du moteur électrique.

4. Moteur électrique selon l'une des revendications 2 ou 3, **caractérisé en ce que** le ressort de contact (10) est collé sur l'élément porteur (6) du moteur électrique.

5. Moteur électrique selon l'une des revendications précédentes, **caractérisé en ce que** l'élément porteur (6) se compose d'une matière plastique isolante.

6. Moteur électrique selon l'une des revendications précédentes, **caractérisé en ce que** les composants CMS (5) sont calés de manière électriquement conductrice aux languettes de contact (2), notamment par serrage et/ou brasage ou par collage conducteur.

7. Moteur électrique selon l'une des revendications précédentes, **caractérisé en ce que** les composants CMS (5) sont enrobés dans un matériau isolant ou en sont revêtus.

8. Moteur électrique selon la revendication 7, **caractérisé en ce que** le matériau isolant est flexible et élastique.

9. Moteur électrique selon l'une des revendications précédentes, **caractérisé en ce qu'**une paroi de protection isolante est disposée entre les composants CMS (5) voisins pour éviter les courts-circuits.

10. Pièce de liaison pour un moteur électrique selon l'une des revendications précédentes, destinée à relier une pluralité de composants CMS disposés dans des cavités ou des chambres d'un élément porteur du moteur électrique avec une partie de carter électriquement conductrice du moteur électrique, laquelle est réalisée sous la forme d'un ressort de contact (10), **caractérisée en ce que** la pièce de liaison possède une portion principale (1), une pluralité de languettes de contact flexibles (2) pour les composants CMS (5), qui s'étendent depuis un côté de celle-ci, et au moins une portion de contact flexible (3), qui s'étend depuis l'autre côté de la portion principale (1), pour la partie de carter électriquement conductrice, le ressort de contact (10) possédant une portion principale (1) en forme de U de l'une des branches duquel partent les languettes de contact (2) et de l'autre branche duquel part au moins une portion de contact (3), et la portion principale (1) possédant le ressort de contact (10) sur le côté des languettes de contact (2) pour les composants CMS (5) et/ou, sur le côté de l'au moins une portion de contact flexible (3) pour la partie de carter, au moins une pince de blocage (7) qui est réalisée sous la forme d'une portion faisant saillie vers l'intérieur.
